# DEMANDE DE BREVET EUROPEEN

(11) **EP 2 765 433 A1**
(43) Date de publication de la demande: **13.08.2014**
(21) Numéro de dépôt: 14153973.4
(22) Date de dépôt: 05.02.2014
(51) Int. Cl.: G01R 31/34, G01R 15/18, H02P 29/00

(54) **Dispositif de mesure de courants rotoriques sur une machine tournante**

(30) Priorité: 06.02.2013 FR 1351004
(71) Demandeur: Alstom Technology Ltd, 5400 Baden (CH)
(72) Inventeur: Mironneau, Jean-Francois, 69003 Lyon (FR); Granelli, Guillaume, 38530 Chapareillan (FR); Juge, Patrice, 74150 Marcellaz Albanais (FR)
(74) Mandataire: Augarde, Eric

(57) **Abrégé**

L'invention concerne un système de mesure de courant rotorique d'une machine tournante (13), comportant au moins un capteur (19) de Rogowski adapté pour être installé au niveau d'un conducteur d'alimentation (9) du rotor de la machine tournante et configuré pour mesurer un signal de courant rotorique à fréquence variable, ledit courant rotorique étant destiné à commander la vitesse de rotation de la machine tournante (13).

## Description

### DOMAINE TECHNIQUE

La présente invention concerne de manière générale l'électronique de puissance et plus particulièrement la mesure du courant sur une machine tournante à vitesse variable.

### ÉTAT DE LA TECHNIQUE ANTÉRIEURE

Les sources d'énergie alternatives telles que les éoliennes, les génératrices marémotrices ou encore les centrales hydroélectriques ne sont pas linéaires et fournissent par conséquent une puissance fluctuante. Par conséquent, l'utilisation croissante de ces sources d'énergies dans un réseau d'électricité nécessite une gestion fine de la puissance qu'elles fournissent afin de répondre au mieux aux besoins du réseau.

A cette fin, la puissance générée/absorbée par les sources d'énergie alternative doit être modulée en fonction de la demande du réseau.

Les nouvelles générations de machines tournantes utilisées dans les sources d'énergie alternatives, sont équipées d'onduleurs/redresseurs à fréquence variable ou VSI (pour Voltage Source Inverter) situés en amont du rotor de l'alternateur de la machine.

Les VSI sont utilisés pour réguler la vitesse de rotation des rotors en envoyant un signal de courant à fréquence variable et à tension constante au rotor. Ce signal modifie par exemple la disposition du rotor par rapport au stator afin de diminuer ou d'augmenter la puissance fournie par la machine.

On comprend alors que la mesure des courants issus des VSI est primordiale pour la gestion fine de la puissance fournie par une machines tournante, utilisée dans les sources d'énergie alternatives. D'autre part, ces courants doivent être en permanence contrôlés afin de mettre en oeuvre des systèmes de protection, comme des relais.

Le signal du courant issu d'un VSI est composé de multiples harmoniques et par conséquent, il doit être mesuré par des capteurs larges bandes, du DC jusqu'à plusieurs dizaines de kHz. Les harmoniques de rangs élevées, c'est-à-dire de rang 100, de ce signal doivent en effet pouvoir être mesurés pour la commande précise du rotor de la machine tournante.

Les capteurs conventionnels, c'est-à-dire avec noyau magnétique, n'offrent pas à la fois une sensibilité, une bande passante et une précision suffisante pour une telle mesure.

De tels capteurs utilisent le principe de l'effet Hall pour mesurer une tension proportionnelle à l'intensité du courant grâce à des tores secondaires de mesure, isolés du conducteur dans lequel circule le courant à mesurer. Une électronique de contre-réaction permet d'annuler le flux magnétique continu et d'éviter la saturation des noyaux magnétiques. L'électronique de contre-réaction ne permet cependant pas la mesure précise de ces courants.

De plus, les capteurs conventionnels sont massifs et ne peuvent pas être installés facilement au niveau du rotor de la machine tournante.

L'objet de la présente invention est de remédier aux inconvénients précités en proposant un système de mesure fiable pour une protection optimale de la machine tournante.

### EXPOSÉ DE L'INVENTION

Cet objectif est atteint par un système de mesure de courant rotorique d'une machine tournante, comportant au moins un capteur de Rogowski adapté pour être installé au niveau d'un conducteur d'alimentation du rotor de la machine tournante et configuré pour mesurer un signal de courant rotorique à fréquence variable, ledit courant rotorique étant destiné à commander la vitesse de rotation de la machine tournante.

Ainsi, le capteur n'est pas perturbé par des courants de Foucault et peut donc répondre aux courants à changement rapide. En effet, comme il n'a aucun noyau de fer à saturer, il est adapté pour mesurer le signal de courant de manière linéaire même lorsqu'il est soumis à de grands courants comportant des perturbations éventuellement causées par des hautes puissances pulsées.

Avantageusement, le capteur de Rogowski comporte des moyens de traitement de signal configurés pour mesurer le signal de courant sur une large bande de fréquence de quelques dixièmes de hertz à quelques dizaines de hertz et de préférence, d'un dixième de hertz à soixante hertz.

Ainsi, le système de mesure permet de mesurer le courant de manière fiable et avec une dynamique importante sur une large bande de fréquence commençant à partir d'une très faible fréquence et permet de mesurer les harmoniques de rangs élevés pour une bonne surveillance et protection de la machine tournante.

Avantageusement, le système comporte des moyens de mémoire configurés pour sauvegarder des paramètres de calibration.

Ainsi, aucun calibrage n'est nécessaire à l'installation du capteur ou suite à des opérations de maintenance. De plus, ceci permet au capteur de s'adapter à tout type d'installation.

Avantageusement, le capteur de Rogowski comporte une bobine définissant une pluralité de tours d'enroulement autour dudit conducteur d'alimentation. Ceci permet d'accroître la sensibilité de la mesure du signal de courant.

Avantageusement, ledit capteur de Rogowski comporte une bobine ouverte. Ceci permet d'avoir un capteur facilement démontable et remontable.

Avantageusement, ledit capteur de Rogowski comporte une bobine souple. Ceci permet de faciliter davantage l'installation du capteur.

Selon un mode de réalisation, le capteur de Rogowski comporte une bobine constituée de pistes sur un circuit imprimé reliées par des via.

L'invention vise également un système de commande d'une machine tournante comportant un système de mesure selon l'une quelconque des caractéristiques précédentes, comportant en outre des moyens onduleurs/redresseurs connectés audit conducteur d'alimentation du rotor pour alimenter ce dernier en ledit courant rotorique commandant la vitesse de rotation de la machine tournante, et des moyens de surveillance pour surveiller le fonctionnement de la machine tournante en fonction de la mesure dudit signal de courant rotorique.

Ainsi, le système de commande permet de mesurer le courant issu de l'onduleur/redresseur, avec une dynamique importante sur large bande de fréquence et un rang élevé de l'harmonique dans le but d'alimenter en mesure fiable les moyens de surveillance.

Avantageusement, les moyens de surveillance comportent des relais de protection pour arrêter la machine tournante en cas de défaut.

### BRÈVE DESCRIPTION DES DESSINS

D'autres caractéristiques et avantages de l'invention apparaîtront à la lecture du mode de réalisation préférentiel de l'invention fait à titre d'exemple non limitatif en référence aux figures jointes parmi lesquelles :
La Fig. 1 illustre de manière schématique un système de protection d'une machine tournante, selon l'invention ;
La Fig. 2 illustre de manière schématique un capteur de Rogowski, selon l'invention ; et
La Fig. 3 illustre de manière schématique un mode de réalisation d'une bobine de Rogowski.

### EXPOSÉ DÉTAILLÉ DE MODES DE RÉALISATION PARTICULIERS

L'idée à la base de l'invention est de mettre en oeuvre de nouveaux capteurs spécifiques susceptibles de répondre en termes de performances à la mesure des courants issus d'un onduleur/redresseur à fréquence variable au niveau de l'alimentation du rotor d'une machine tournante (générateur/moteur).

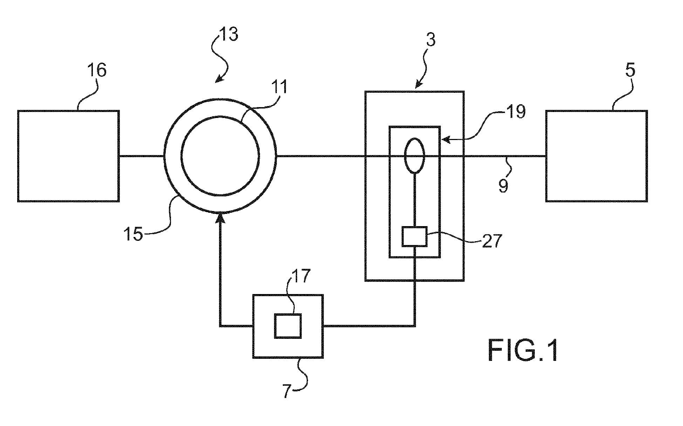

La Fig. 1 illustre de manière schématique un système de protection d'une machine tournante, selon l'invention.

Le système de protection 1 comporte un système de mesure 3, des moyens onduleurs/redresseurs 5, et des moyens de surveillance 7 et de protection.

Les moyens onduleurs/redresseurs 5 à fréquence variable de type VSI sont connectés aux conducteurs d'alimentation 9 du rotor 11 de la machine tournante 13 pour alimenter ce dernier en un courant rotorique commandant la vitesse de rotation de la machine tournante 13.

En effet, le courant rotorique issu des VSI 5 est un courant d'excitation à fréquence variable pour réguler la vitesse de rotation du rotor 11. Ce courant rotorique modifie la disposition du rotor 11 par rapport au stator 15 afin de moduler la puissance fournie par la machine tournante 13 en fonction des besoins du réseau électrique 16.

Le courant rotorique doit être en permanence contrôlé afin de mettre en oeuvre un système efficace de gestion, de surveillance et de protection de la machine tournante 13.

Ainsi, le système de mesure 3 selon l'invention est configuré pour fournir une mesure fiable aux moyens de surveillance 7 et de protection. Ces derniers vérifient le bon fonctionnement de la machine tournante 13 en fonction de la mesure du signal de courant rotorique et comportent des relais de protection 17 pour arrêter la machine 13 en cas de défaut.

Conformément à l'invention, le système de mesure 3 comporte au moins un capteur 19 de type Rogowski adapté pour être installé au niveau d'un conducteur d'alimentation 9 du rotor 11 de la machine tournante 13 et configuré pour mesurer le signal de courant rotorique à fréquence variable issu des VSI.

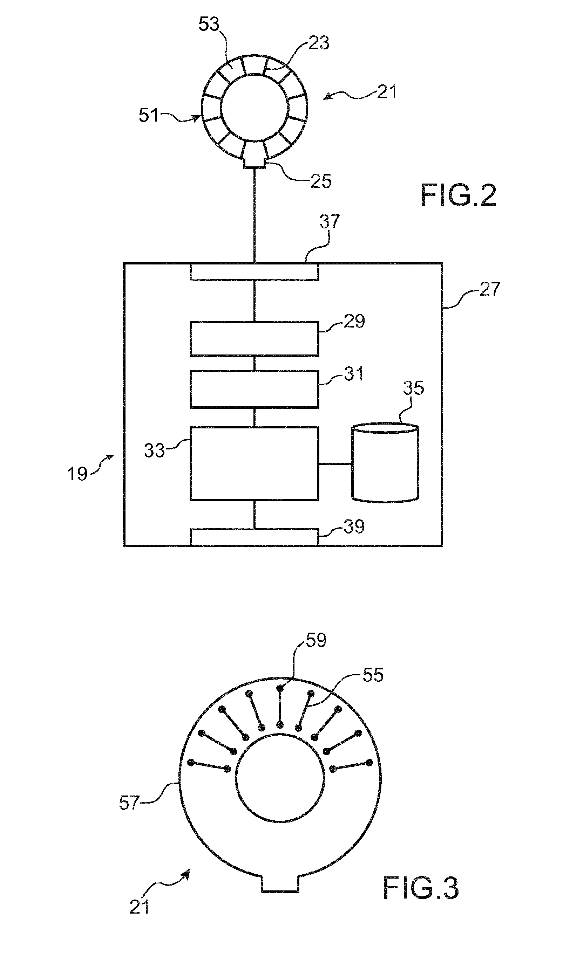

La Fig. 2 illustre de manière schématique un capteur de Rogowski, selon l'invention.

Le capteur 19 comporte une bobine de Rogowski 21 de forme principale annulaire destiné à être monté autour du conducteur d'alimentation 9 du rotor 11. La bobine 21 se présente sous la forme d'un double enroulement hélicoïdal d'un fil 23 dont une partie est enroulé dans un sens et dont l'autre partie est enroulé dans le sens opposé. Les deux extrémités du fil 23 sont reliées à une borne de connexion 25.

Le signal de tension recueilli à la borne de connexion 25 est représentatif de la dérivée du signal du courant et par conséquent, l'intégration de la tension permet de déterminer le signal de courant.

La bobine 21 de Rogowski ne comporte aucun noyau de fer à saturer. Ainsi, il est adapté pour mesurer le signal de courant de manière linéaire même lorsque le courant est très haché ou très perturbé. De plus, il est immunisé contre les interférences électromagnétiques.

La bobine de Rogowski présente une grande précision grâce à une absence de saturation magnétique, une sécurité intrinsèque, des compacité et modularité accrues, une quasi absence de maintenance, une souplesse d'utilisation, une facilité de montage, et une réduction globale des coûts.

En outre, la petite taille modulable d'une bobine 21 de Rogowski est compatible avec son utilisation au niveau du rotor 11 de la machine tournante 13.

Le capteur de Rogowski comporte aussi un dispositif de traitement 27 relié à la bobine 23 pour traiter le signal mesuré par cette dernière.

Le dispositif de traitement 27 comporte des moyens d'intégration 29, des moyens de conversion analogique/numérique 31, des moyens de traitement 33 de signal, des moyens de mémoire 35, des moyens d'entrée 37, et des moyens de sortie 39.

Les moyens d'intégration sont destinés à intégrer le signal de tension recueilli par la bobine 23 de Rogowski pour donner le signal de courant rotorique.

Les moyens de conversion analogique/numérique 31 sont destinés à convertir le signal de courant rotorique en un signal numérique qui est ensuite analysé par les moyens de traitement 33. En variante, on peut d'abord convertir le signal de tension en un signal numérique de tension et ensuite, intégrer ce dernier pour obtenir un signal numérique de courant.

Les moyens de traitement 33 de signal sont configurés pour faire un traitement de grande précision afin de mesurer le signal de courant sur une large bande de fréquence de quelques dixièmes de hertz à quelques dizaines de hertz et de préférence, d'un dixième de hertz à soixante hertz. Ceci étant rendu possible par la mise en place d'un étage d'entrée spécifique basé sur l'utilisation d'amplificateurs à gains élevés.

Plus particulièrement, les moyens de traitement 33 mettent en oeuvre un algorithme permettant notamment la mesure de signaux à des fréquences très basses, basé sur un temps d'intégration augmenté associé à un filtrage de type passe-bas évolué avec un ordre supérieur ou égal à 8 appliqué à un filtre par exemple de type Tchebychev. Ceci permet de mesurer des signaux de courant rotorique issus du VSI qui peuvent être à la fois de très basse fréquence et composés de multiples harmoniques.

Ensuite, les moyens de sortie 39 délivrent la mesure numérique traitée du signal de courant rotorique aux moyens de surveillance et de protection 7.

En outre, les moyens de mémoire 35 sont configurés pour sauvegarder une pluralité de paramètres de calibration permettant le remplacement du capteur 19 par un autre capteur sorti de fabrication sans avoir à calibrer la chaîne complète d'acquisition. Ces paramètres qui sont sauvegardés dans les moyens de mémoire 35 sont déterminés lors de la fabrication et du processus de calibration du capteur.

Les différents dispositifs de traitement 27 reliés à des différentes bobines 21 de Rogowski sont avantageusement reliés à une unité centrale de regroupement (non représentée) pour centraliser l'acquisition des différents capteurs.

On notera que les bobines 21 de Rogowski peuvent être rigides en forme de tore mais idéalement souple et ouvert pour une installation aisée autour des conducteurs d'alimentation 9 rotoriques.

Avantageusement, la bobine 21 de Rogowski comporte une pluralité de tours d'enroulement autour du conducteur d'alimentation 9 pour accroître la sensibilité de la mesure du signal de courant.

Selon un premier mode de réalisation, la bobine de Rogowski se présente sous la forme d'un tore 51 avec un fil 23 bobiné autour d'une âme centrale 53.

Le diamètre intérieur du tore 51 est adapté au conducteur d'alimentation 9 autour duquel il est destiné à être monté. La longueur déroulée du tore dépend aussi du diamètre du conducteur d'alimentation et du nombre de tours à effectuer pour accroître la sensibilité.

Le tore 51 a par exemple une section externe de l'ordre d'une dizaine de millimètres (par exemple, 12mm) et présente une section de couplage aux champs magnétiques de quelques millimètres (par exemple, 8mm).

Selon un deuxième mode de réalisation, la bobine de Rogowski représentée sur la Fig. 3 est constituée de pistes 55 reliées par des via sur une carte 57 de circuit imprimé.

En particulier, le bobinage est constitué d'un ensemble de pistes 55 en matériau conducteur électrique recouvrant les deux faces radiales de la carte 57 du circuit imprimé. Des trous 59 métallisés qui traversent la carte 57 du circuit imprimé au niveau des extrémités des pistes 55 relient les pistes situées sur une face de la carte 57 aux pistes situées sur l'autre face de la carte.

Le diamètre intérieur de la carte 57 est adapté au diamètre du conducteur d'alimentation 9 autour duquel le capteur est destiné à être monté.

Pour accroître la sensibilité du capteur, on peut utiliser une pluralité de cartes 57 du type de celle de la Fig. 4, superposées et séparées entre elles par des couches isolantes.

## Revendications

1. Système de mesure de courant rotorique d'une machine tournante (13), **caractérisé en ce qu'**il comporte au moins un capteur (19) de Rogowski adapté pour être installé au niveau d'un conducteur d'alimentation (9) du rotor de la machine tournante, ledit capteur de Rogowski comportant des moyens de traitement (33) de signal configurés pour mesurer un signal de courant rotorique à fréquence variable sur une large bande de fréquence de quelques dixièmes de hertz à quelques dizaines de hertz, ledit courant rotorique étant destiné à commander la vitesse de rotation de la machine tournante (13).

2. Système selon la revendication 1, **caractérisé en ce que** les moyens de traitement (33) de signal sont configurés pour mesurer le signal de courant sur une large bande de fréquence d'un dixième de hertz à soixante hertz.

3. Système selon la revendication 1 ou 2, **caractérisé en ce qu'**il comporte des moyens de mémoire (35) configurés pour sauvegarder des paramètres de calibration.

4. Système selon l'une quelconque des revendications précédentes, **caractérisé en ce que** le capteur de Rogowski comporte une bobine (21) définissant une pluralité de tours d'enroulement autour dudit conducteur d'alimentation (9).

5. Système selon l'une quelconque des revendications précédentes, **caractérisé en ce que** ledit capteur (19) de Rogowski comporte une bobine ouverte.

6. Système selon l'une quelconque des revendications précédentes, **caractérisé en ce que** ledit capteur (19) de Rogowski comporte une bobine souple.

7. Système selon l'une quelconque des revendications 1 à 5, **caractérisé en ce que** le capteur de (19) Rogowski comporte une bobine constituée de pistes (55) sur une carte (57) de circuit imprimé reliées par des via.

8. Système de commande d'une machine tournante comportant un système de mesure selon l'une quelconque des revendications précédentes, **caractérisé en ce qu'**il comporte en outre des moyens onduleurs/redresseurs (5) connectés audit conducteur d'alimentation (9) du rotor (11) pour alimenter ce dernier en ledit courant rotorique commandant la vitesse de rotation de la machine tournante (13), et des moyens de surveillance (7) pour surveiller le fonctionnement de la machine tournante en fonction de la mesure dudit signal de courant rotorique.

9. Système de commande selon la revendication 8, **caractérisé en ce que** les moyens de surveillance comportent des relais de protection (17) pour arrêter la machine tournante en cas de défaut.
